(19) Europäisches Patentamt
European Patent Office
Office européen des brevets

(11) **EP 1 482 288 B1**

(12) **FASCICULE DE BREVET EUROPEEN**

(45) Date de publication et mention
de la délivrance du brevet:
**04.04.2018 Bulletin 2018/14**

(51) Int Cl.:
***G01J 3/453*** *(2006.01)*

(21) Numéro de dépôt: **04011648.5**

(22) Date de dépôt: **17.05.2004**

(54) **Spectromètre statique par transformée de Fourier**

Statisches Fouriertransformspektrometer

Static Fourier-Transform Spectrometer

(84) Etats contractants désignés:
**DE FR GB**

(30) Priorité: **28.05.2003 FR 0306548**

(43) Date de publication de la demande:
**01.12.2004 Bulletin 2004/49**

(73) Titulaire: **ONERA (Office National d'Etudes et de Recherches Aérospatiales)**
**91120 Palaiseau (FR)**

(72) Inventeurs:
• **Guerineau, Nicolas**
**92160 Antony (FR)**
• **Deschamps, Joel**
**91460 Marcoussis (FR)**
• **ROMMELUERE, Sylvain**
**92190 Meudon (FR)**

(74) Mandataire: **Gevers & Orès**
**41 avenue de Friedland**
**75008 Paris (FR)**

(56) Documents cités:
**CA-A1- 2 302 994     US-A- 4 822 998**
**US-A- 6 016 199**

• **Hilary E Snell ET AL: "Fourier Transform Fabry-Perot Interferometer", SPIE - International Society for Optical Engineering. Proceedings, vol. 1745, 29 June 1992 (1992-06-29), XP055337067, US ISSN: 0277-786X, DOI: 10.1117/12.60609 ISBN: 978-1-5106-0753-8**

## Description

La présente invention concerne la détection et l'analyse quantitative du contenu spectral d'une onde lumineuse. Plus particulièrement, elle a trait à un spectromètre statique par transformée de Fourier incluant un photodétecteur à éléments semi-conducteurs sensibles particulièrement à un rayonnement incident et un interféromètre statique à deux ondes comprenant un dioptre semi-réfléchissant.

L'interféromètre par exemple du type Michelson à séparateur d'onde et deux miroirs impose une différence de marche entre deux ondes majoritaires au moyen d'un positionnement en translation ou rotation de l'un des miroirs par rapport à l'autre. L'intensité de l'onde résultant du déphasage des deux ondes majoritaires réfléchies par les miroirs est variable en fonction du déplacement du miroir et forme un interférogramme sur le détecteur. L'interférogramme représente une variation de l'intensité lumineuse reçue par le détecteur en fonction du déphasage ce qui permet de déduire par transformée de Fourier, après échantillonnage, l'intensité spectrale en fonction de la fréquence.

Le photodétecteur est utile à la détection et l'analyse quantitative du contenu spectral d'une onde lumineuse. L'analyse contribue à la définition des propriétés optiques en émission et réflexion d'une source de rayonnement, telle qu'une scène observée, ainsi que du milieu de propagation entre cette source et le photodétecteur. Cette mesure effectuée à différents instants identifie les phénomènes physiques mis en jeu au cours de l'émission puis de la propagation d'un tel rayonnement ainsi que leur évolution au cours du temps. Lorsque le photodétecteur est couplé à un système de prise de vue dit imageur, chaque point de la scène observée et la signature spectrale de celui-ci sont associés pour faire ainsi de la spectro-imagerie.

On connaît des spectromètres à transformée de Fourier statiques, décrits dans l'article intitulé "Performance limits of stationary Fourier spectrometers", M.-L. Junttila et al., Journal of Optical Society of America, Vol. 8, N° 9, Septembre 1991, p. 1457-1462, dont les avantages en termes de résolution, largeur spectrale, sensibilité radiométrique et cadence d'acquisition sont établis. L'interféromètre du type Michelson à séparateur de faisceau semi-réfléchissant et deux miroirs, ou du type Mach-Zehnder modifié à séparateur de faisceau semi-réfléchissant et trois miroirs, ou du type triangulaire à séparateur de faisceau semi-réfléchissant et deux miroirs en regard, divise une onde lumineuse incidente en deux ondes réfléchies déphasées présentant des différences de marche qui génèrent un interférogramme sur un plan d'observation constitué par la face photosensible du détecteur. L'interférogramme reproduit dans le plan d'observation est échantillonné par un ensemble linéaire ou matriciel d'éléments photosensibles élémentaires.

La gamme spectrale d'analyse de ce type de spectromètres est bornée par les longueurs d'onde $\lambda$ min et $\lambda_{max}$. La borne inférieure $\lambda_{min}$ est liée au pas d'échantillonnage $d\delta$ de l'interférogramme par la formule suivante :

$$\lambda_{min} = 2d\delta$$

La borne supérieure est définie, en pratique, par la sensibilité du détecteur qui devient aveugle au-delà de la valeur $\lambda_{max}$.

La résolution spectrale $d\lambda$ du spectromètre pour l'analyse d'une onde lumineuse de longueur d'onde $\lambda$ est liée à la différence de marche maximale $\delta_{max}$ créée par l'interféromètre entre les deux ondes par la formule suivante :

$$d\lambda = \lambda^2 / (2\ \delta_{max})$$

De tels spectromètres ont de grandes performances sur le plan théorique mais présentent des limitations pratiques de mise en oeuvre, notamment liées au réglage opto-mécanique de l'interféromètre. Celui-ci s'avère fastidieux à régler notamment dans des domaines de rayonnement où les moyens de contrôle ne sont pas visuels. Dans le cas de la spectrométrie infrarouge de scènes à faibles flux lumineux, il est nécessaire de refroidir l'ensemble du spectromètre afin de réduire les contributions thermiques liées au spectromètre. Ces contraintes pratiques intrinsèques au spectromètre, ajoutées aux contraintes extérieures liées aux conditions d'expérimentation, embarquées ou sur le terrain, conduisent à la réalisation de prototypes de spectromètre coûteux, fragiles et encombrants.

En revanche, les détecteurs linéaires ou matriciels, utilisés dans ce type de spectromètre ont bénéficié durant la dernière décennie de progrès technologiques considérables ayant permis d'aboutir à la production en grande série de barrettes et matrices photosensibles comportant un grand nombre de détecteurs élémentaires avec des performances élevées.

Afin de réduire les inconvénients des spectromètres précédents dus à leurs interféromètres, Omar Manzardo et al. ont cherché selon leur article intitulé "Miniaturized time-scanning Fourier transform spectrometer based on silicon technology", Optics Letters, Vol. 24, N° 23, Décembre 1999, p. 1705-1707, à miniaturiser un interféromètre à séparateur et deux miroirs en un microsystème ayant des dimensions compatibles avec des formats de circuits intégrés. L'un des miroirs est déplacé linéairement par un actionneur à peigne électrostatique. Cette technologie nécessite des étapes technologiques supplémentaires pour concevoir et réaliser le microsystème qui doit ensuite être couplé à une matrice d'éléments photosensibles d'un détecteur.

Par ailleurs, on connaît :

- par le document US 6 016 199, un spectromètre statique par transformée de Fourier comprenant un interféromètre de type Fabry-Pérot ;
- par le document US 4 822 998, un capteur spectral statique comprenant un filtre d'interférence agencé sur un interféromètre ;
- par le document CA 4820 998, un spectromètre statique par transformée de Fourier dont l'interféromètre comprend un élément de profil en marche d'escalier ; et
- par l'article intitulé « Fourier Transform Fabry-Pérot Interferometer », H.E. Snell et al, SPIE-International Society for Optical Engineering, Vol. 1745, 29 juin 1992, p. 158-163, une étude sur la faisabilité d'un interféromètre Fabry-Pérot par transformée de Fourier.

L'objectif de la présente invention est d'intégrer, au moment de la phase de fabrication, une fonction d'interféromètre statique à deux ondes sur un photodétecteur afin de constituer un spectromètre statique miniature par transformée de Fourier fonctionnant particulièrement dans l'infrarouge.

Pour atteindre cet objectif, selon un premier mode de réalisation, un spectromètre statique par transformée de Fourier comprenant des éléments photosensibles semi-conducteurs ayant des faces actives coïncidant avec un plan d'image, et un dioptre semi-réfléchissant, le spectromètre comprenant un interféromètre essentiellement constitué par une lame, la lame ayant une première face plane coïncidant avec le plan d'image sur les éléments photosensibles, et une deuxième face plane non parallèle à la première face et supportant le dioptre semi-réfléchissant afin que l'épaisseur entre les faces de la lame, sensiblement constante en regard de chaque élément photosensible, varie régulièrement d'un élément photosensible à un autre.

Selon l'invention, la première face plane de la lame constituant l'interféromètre coïncide avec le plan d'image et donc coïncide avec les faces actives des éléments photosensibles du détecteur, sans aucun dioptre intermédiaire ; par conséquent l'interféromètre à lame est complètement intégré sur le détecteur, et l'interféromètre et le détecteur ne sont pas deux éléments physiquement séparables dont l'un est rapporté sur l'autre, par toute technique de fixation, telle que collage.

Ainsi, la variation d'épaisseur entre les faces de la lame induit une variation linéaire de différence de marche optique $\delta$ entre une valeur minimale $\delta_{min}$ et une valeur maximale $\delta_{max}$ avec un pas d'échantillonnage d$\delta$. Alternativement, selon un deuxième mode de réalisation, la deuxième face de la lame peut être constituée de marches sensiblement aussi larges qu'au moins un élément photosensible.

Le spectromètre de l'invention comporte un interféromètre essentiellement constitué par la lame et ayant un séparateur d'onde constitué par la première face plane coïncidant avec les faces de la zone active du détecteur et un unique miroir constitué par la deuxième face non parallèle du type semi-réfléchissante. La zone active du détecteur comprend un ensemble d'éléments photosensibles.

Chaque élément photosensible du détecteur constitue un point d'image élémentaire appelé pixel qui est en regard d'une zone de la lame. Cette zone constitue un interféromètre élémentaire à deux ondes majoritaires. Le paramètre de déphasage entre ces deux ondes est directement lié à l'épaisseur de la lame dans cette zone.

Grace à la variation de l'épaisseur de lame d'une zone à l'autre et donc du paramètre de déphasage d'un pixel à l'autre, on obtient un spectromètre statique à transformée de Fourier. La localisation relative sur le plan de détection d'une zone induisant une différence de marche $\delta$ avec une zone induisant une différence de marche $\delta + d\delta$ ou $\delta - d\delta$ peut être quelconque. Le spectomètre selon l'invention est donc très compact puisque le plan d'image coïncide à la fois avec la première face de la lame et les faces actives des éléments photosensibles, et donc puisqu'il intègre contre le détecteur un interféromètre à deux ondes bénéficiant à la fois des technologies actuelles de fabrication des détecteurs et des performances intrinsèques à la spectrométrie statique par transformée de Fourier.

L'invention concerne également un procédé de fabrication d'un spectromètre statique par transformée de Fourier comprenant des éléments photosensibles semi-conducteurs ayant des faces actives coïncidant avec un plan d'image, et un dioptre semi-réfléchissant, le spectromètre comprenant un interféromètre essentiellement constitué par une lame. Le procédé par intégration d'un interféromètre sur un détecteur pour constituer le spectomètre de l'invention est caractérisé en ce qu'il comprend les étapes suivantes de :

- former les éléments photosensibles avec leurs faces actives sur une première face d'un substrat coïncidant avec le plan d'image,
- amincir le substrat en une lame ayant une deuxième face plane non parallèle à la première face du substrat afin que l'épaisseur entre les faces de la lame varie d'un élément photosensible à l'autre, et
- déposer une couche semi-réfléchissante formant le dioptre semi-réfléchissant sur la deuxième face. Dans un procédé alternatif, la deuxième face de la lame peut être constituée de marches sensiblement aussi larges qu'au moins un élément photosensible.

De préférence, la fabrication du spectromètre comprend une intégration d'un circuit de lecture sur les éléments photosensibles par technique d'hybridation, après l'étape de former.

D'autres caractéristiques et avantages de la présente invention apparaîtront plus clairement à la lecture de la description suivante de plusieurs réalisations préférées de l'invention en référence aux dessins annexés correspondants dans lesquels :

- la figure 1 est une vue en coupe d'un élément photosensible en regard d'une zone de la lame à faces parallèles dans un spectromètre miniature selon l'invention ;
- la figure 2 est une vue en coupe schématique d'un spectromètre à lame en coin et faces planes selon un premier mode de réalisation de l'invention ;
- la figure 3 montre des étapes d'un procédé de fabrication du spectromètre montré à la figure 2 ;
- la figure 4 est une vue en coupe schématique, selon un plan perpendiculaire à la première face plane, d'un spectromètre à lame avec une face en escalier selon un deuxième mode de réalisation de l'invention ;
- la figure 5 est une vue en perspective schématique d'une lame ayant une face dont l'épaisseur croît en marche d'escalier suivant une spirale;
- les figures 6A et 6B montrent schématiquement un emploi de microspectromètres de l'invention pour spectrométrie moyenne ou haute résolution ;
- la figure 7 montre un emploi d'un spectromètre selon l'invention pour de la spectrométrie et de l'imagerie simultanées ; et
- la figure 8 montre un emploi d'un spectromètre selon l'invention pour de la spectrométrie et de l'imagerie séquentielles.

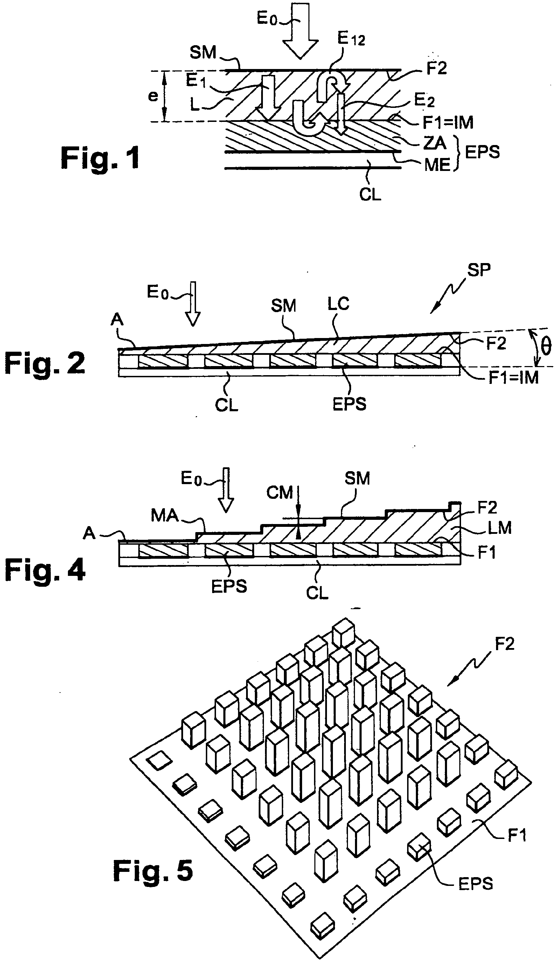

En référence à la figure 1, on considère un élément photosensible EPS à hétérostructure semiconductrice dans un détecteur. L'élément EPS est relatif à un élément d'image détecté et est appelé pixel. Il présente une face sensible constituant un plan d'image IM sur une zone active photosensible ZA qui absorbe la majeure partie d'une onde incidente E1. L'autre face de l'élément EPS intègre un circuit de lecture CL incluant des électrodes et séparé par une couche isolante de la zone active ZA. La zone active ZA et le circuit de lecture CL sont combinés selon une technique d'hybridation.

Selon l'invention, une lame L en matériau sensiblement transparent au rayonnement incident est superposée à l'élément photosensible EPS. Par exemple, la lame L est en un composé cristallin incluant un semiconducteur, par exemple un composé tellureux tel que du tellure de cadmium et zinc Cd Zn Te ayant un indice de réfraction n = 2,7. L'épaisseur e de la lame est de quelques micromètres à quelques dizaines de micromètres. Une première face F1 de la lame L coïncide avec le plan d'image IM et donc la face photosensible de l'élément EPS. Une deuxième face F2 de la lame L confondue avec le dioptre milieu de propagation-lame est recouverte d'une ou plusieurs couches minces SM, diélectriques ou métalliques, permettant de rendre semi-réfléchissant le dioptre milieu de propagation-lame dans la bande spectrale d'analyse. La première face F1 et la deuxième face F2 correspondent respectivement à une face "avant" et une face "arrière" d'un substrat en le matériau sensiblement transparent au début de la fabrication du spectromètre selon l'invention, avant retournement et usinage du substrat, comme cela sera expliqué plus loin.

Lorsqu'une onde incidente E0 à incidence normale tombe sur le pixel du spectromètre, une grande partie E1 de l'onde E0 traverse la face semi-réfléchissante F2 de la lame L. L'onde incidente E1 interne à la lame est séparée par le dioptre lame-zone active F1 en une partie majoritaire absorbée par la zone active ZA de l'élément EPS et une partie minoritaire E12 réfléchie vers la face semi-réfléchissante F2. La partie d'onde E12 est à son tour partiellement réfléchie dans la lame L par la face semi-réfléchissante F2 en une onde réfléchie E2 ayant 5 à 10 pour cent environ de l'énergie de l'onde incidente interne E1. Les ondes E1 et E2 constituent deux ondes majoritaires, d'autres séparations et réflexions supérieures au premier ordre étant négligeables.

Les ondes majoritaires E1 et E2 interfèrent sur le plan d'image IM et produisent sur la face photosensible F1 d'une rangée ou d'une matrice d'éléments photosensibles EPS dans le détecteur, un interférogramme transmis par le circuit de lecture CL à des moyens électriques connus d'analyse spectrale (non représentés).

L'onde E2 parcourt une différence de marche optique $\delta$ supplémentaire par rapport à l'onde E1, donnée par la formule suivante :

$$\delta = 2ne$$

Dans un spectromètre SP selon l'invention, l'épaisseur e de la lame LC varie d'un élément à l'autre suivant, par exemple, une direction, c'est-à-dire suivant la rangée d'éléments photosensibles d'un détecteur linéaire, ou suivant chacune des rangées parallèles, lignes ou colonnes, d'éléments photosensibles d'un détecteur matriciel. On aboutit à un interféromètre statique sur toute la surface du détecteur sur laquelle l'interférogramme présente des franges contrastées ce qui facilite l'échantillonnage de l'interférogramme par les moyens d'analyse spectrale.

Comme illustré à la figure 2, on a représenté une rangée de quelques éléments photosensibles EPS sur laquelle la lame LC a une face semi-réfléchissante plane F2 qui n'est pas parallèle à la face de plan d'image F1. En pratique, une rangée, telle que ligne ou colonne, comprend plus d'une centaine d'éléments photosensibles.

La lame LC a une forme de coin, c'est-à-dire de dièdre ayant des demi-plans coplanaires aux faces F1 et F2 et un angle $\theta$ de quelques dizaines de milliradian. L'épaisseur entre les faces F1 et F2 de la lame est dite sensiblement constante dans la zone en regard d'un élément photosensible EPS dans le sens où les effets de la variation d'épaisseur locale liée à tg ($\theta$) sont négligés sur la zone.

L'arête A du dièdre est sensiblement perpendiculaire à chaque rangée d'éléments photosensibles. La rangée d'éléments photosensibles EPS est alors soumise à un éclairement incident E0 qui comporte une modulation sinusoïdale de période $\lambda$ /n si on l'éclaire avec une onde monochromatique de longueur d'onde $\lambda$. En éclairage polychromatique, la répartition spatiale d'éclairement le long de la rangée de pixels s'écrit alors comme une superposition incohérente de sinusoïdes de différentes périodes. On se ramène à un interféromètre "classique", c'est-à-dire du type de celui généré par un interféromètre à deux ondes utilisé dans un spectromètre par transformée de Fourier classique. Cependant, dans l'interféromètre de l'invention constitué par la lame en coin LC, la première onde majoritaire E1 interfère sans aucune réflexion sur un miroir, avec la deuxième onde majoritaire E2 qui est réfléchie par un unique miroir constitué par la face semi-réfléchissante plane F2. L'interféromètre de l'invention ne comprend donc qu'un séparateur d'onde F1 et un miroir F2.

La géométrie de la lame LC d'épaisseur variable est obtenue par un amincissement d'un substrat en la matière de la lame au cours de la réalisation du spectromètre de l'invention décrite ci-après.

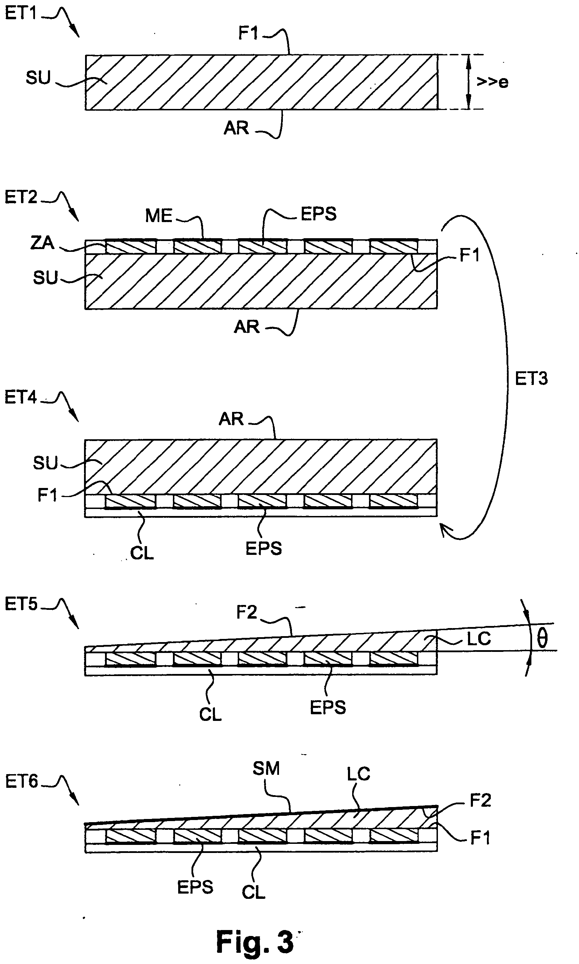

La fabrication d'un spectromètre de l'invention, par exemple matriciel, comprend les étapes principales suivantes ET1 à ET6 montrées à la figure 3. Les étapes ET1 à ET6 sont connues séparément par l'homme du métier mais constituent une combinaison nouvelle et caractéristique de la fabrication.

A l'étape initiale ET1 est utilisé un substrat SU sensiblement transparent, par exemple en Cd Zn Te et d'indice de réfraction n = 2,7, beaucoup plus épais que la lame LC, soit une épaisseur de substrat de 500 $\mu$m environ. Puis on fait croître sur la face "avant" F1 du substrat une zone active photo-absorbante ZA présentant une hétérostructure à différentes couches semi-conductrices et isolantes formant la matrice d'éléments photosensibles EPS. La zone ZA croît jusqu'à une épaisseur de 7 $\mu$m à 10 $\mu$m environ sur la face "avant" du substrat, en utilisant une épitaxie par jet moléculaire ou un dépôt en phase vapeur à l'étape ET2. Une couche de métallisation ME combinée à une couche isolante est déposée et gravée sur la zone active afin de former les électrodes de chaque élément EPS.

Le substrat SU supportant la zone active ZA est ensuite retourné à l'étape ET3. La face du substrat initialement avant reçoit, au niveau de la couche de métallisation ME contre les éléments photosensibles EPS, le circuit de lecture CL selon une technique d'intégration afin de constituer un circuit hybride ZA+CL, à l'étape ET4. Le circuit de lecture peut comprendre des registres à décalage pour des lignes et/ou colonnes d'éléments photosensibles. En variante, l'étape d'intégration ET4 précède l'étape de retournement ET3.

La face "arrière" AR du substrat SU, maintenant supérieure, est attaquée mécaniquement par abrasion ou chimiquement par érosion ionique à l'étape ET5. Cette attaque amincit considérablement le substrat en matière transparente en une lame dont la face F2 n'est pas parallèle à la face "avant" du substrat. Cette attaque peut amincir, par exemple, le substrat en une lame en coin LC dont l'épaisseur varie de 1 à 2 $\mu$m environ à 10 $\mu$m environ et dont l'angle de dièdre $\theta$ est de quelques milliradians, typiquement 8 à 12 milliradians.

La face plane F2 de la lame LC, qui n'a subi aucun traitement antireflet, reçoit finalement à l'étape ET6 un dépôt de plusieurs couches minces diélectriques empilées formant une couche semi-réfléchissante SM. Cette dernière augmente le contraste des franges des interférogrammes à détecter par augmentation de l'intensité de la deuxième onde majoritaire réfléchie E2.

De nombreuses topographies d'épaisseur de lame pour un spectromètre avec un détecteur linéaire ou matriciel de M * N éléments photosensibles entrent dans le cadre de l'invention.

Selon une deuxième réalisation montrée à la figure 4, un amincissement par marche d'escalier, évite des variations d'épaisseur locales, au niveau de chaque élément. Chaque marche MA est sensiblement aussi large qu'au moins un élément photosensible comme montré à la figure 1 ou, en variante, de quelques éléments photosensibles EPS d'une rangée ou d'une colonne. La deuxième face F2 de la lame dont le profil est en marche d'escalier LM accentue encore le contraste des franges pour l'analyse des longueurs d'onde proches de $\lambda_{min}$ en évitant les effets de filtrage spatial des pixels. La contre-marche CM entre deux marches consécutives est alors choisie sensiblement égale à $\lambda_{min}$ /4n, c'est-à-dire au pas d'échantillonage d$\delta$ défini plus haut.

Tous les éléments photosensibles d'une même ligne ou d'une même colonne de la matrice sont sous la même épaisseur de la lame LM. Ceci laisse la possibilité de moyenner les réponses des éléments photosensibles EPS identiques suivant la direction de la ligne ou colonne d'épaisseur constante pour augmenter le rapport signal sur bruit dans le cas de la spectrométrie à faible flux lumineux. Cette direction peut aussi être utilisée pour faire de l'imagerie suivant une direction.

Selon une autre réalisation avec une matrice d'éléments photosensibles EPS, l'épaisseur de la lame d'interféromètre LC, LM varie de manière continue ou par marches en partant de l'élément photosensible d'un coin de la matrice, en montant en spirale parallèlement aux bords de la matrice et en finissant à l'élément photosensible central, comme montré à la figure 5. Dans cette figure, les éléments photosensibles EPS ont été montrés d'une manière disjointe afin de clarifier le profil en spirale de la face F2 de la lame d'interféromètre, bien qu'en pratique les éléments photosensibles formant les marches de la spirale se suivent d'une manière continue. La lame a alors une forme pyramidale présentant l'avantage de ramener les surépaisseurs faibles sur les bords de la matrice, là où les contraintes thermiques sont les plus fortes entre le circuit de lecture en silicium et le substrat en tellure de cadmium et zinc (Cd Zn Te) par exemple. Cette configuration qui exploite un nombre total d'éléments photosensibles EPS typiquement jusqu'à plusieurs dizaines de milliers sur une matrice 320 x 240 pixels avec un pas de quelques micromètres, est particulièrement bien adaptée à la spectrométrie haute résolution inférieure au cm$^{-1}$, application qui nécessite un grand nombre de points d'échantillonnage.

Selon encore une autre variante, l'arête A du dièdre n'est pas perpendiculaire à chaque rangée d'éléments photosensibles EPS ce qui permet un suréchantillonnage d'interférogrammes et remédie à des repliements de spectre. Cette technique est décrite dans l'article intitulé "Simple infrared Fourier transform spectrometer adapted to low light level and high-speed", Philippe Voge et Jérôme Primot, Optical Engineering, Vol. 37, N°9, septembre 1998, p. 2459-2466.

Le spectromètre statique par transformée de Fourier selon l'invention présente particulièrement les avantages suivants :

- extrême compacité grâce à sa fabrication sur un substrat SU en la matière de la lame d'interféromètre LC, LM pour ne former qu'un seul composant (chip) intégrant à la fois l'interféromètre et le détecteur photosensible ce qui simplifie la réalisation ;
- potentialités d'évolution importantes pour diverses configurations d'emploi pour satisfaire différentes applications de spectrométrie et/ou d'imagerie, comme on le verra plus loin.

Des mesures de cartographie de réponses spectrales ont été effectuées avec des spectromètres à photodétecteur matriciel et lame d'interféromètre en forme de coin selon l'invention. La lame LC présentait un amincissement en biais suivant un angle θ d'une dizaine de milliradians et aucun traitement antireflet sur la deuxième face F2. Ces mesures reviennent après traitement à éclairer le spectromètre SP avec une onde quasi-plane et quasi-monochromatique, de largeur spectrale dλ, centrée sur une longueur d'onde λ variant de 2 μm à 12 μm environ. Des interférogrammes obtenus à différentes longueurs d'onde λ montrent clairement l'apparition de franges d'interférence qui couvrent sensiblement toute la surface de la matrice d'éléments photosensibles EPS lorsque la largeur spectrale dλ est faible et qui couvrent une portion de la matrice lorsque la largeur spectrale dλ augmente. Le contraste apparaissant sur ces interférogrammes permet de détecter des franges d'interférence pour différentes longueurs d'onde entre 2 μm et 12 μm environ. Le traitement semi-réfléchissant de la face en biais F2 de la lame LC contribue à une augmentation du contraste des franges d'interférence.

Trois configurations d'emploi du spectromètre SP selon l'invention représentatives des potentialités de celui-ci en matière de spectrométrie et d'imagerie sont présentées ci-après.

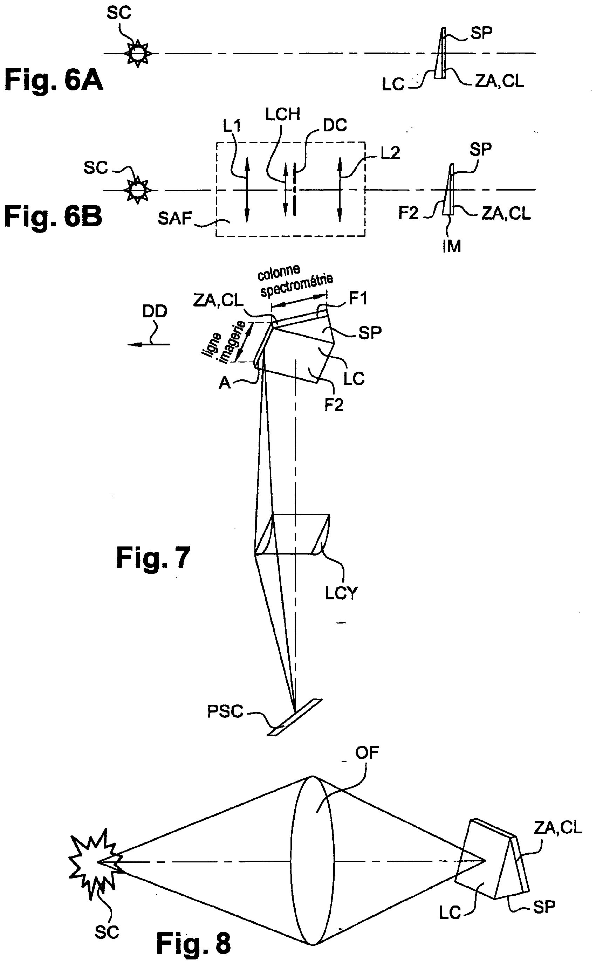

Selon une première configuration, le spectromètre SP est un microspectromètre à spectrométrie moyenne ou haute résolution. Il est positionné dans ou au voisinage d'un plan pupillaire, directement devant une scène lointaine SC à analyser, comme montré à la figure 6A.

Selon une autre variante, le microspectromètre SP est positionné derrière un système afocal SAF délimitant bien le champ de la scène SC à observer, comme montré à la figure 6B. Le système afocal comprend deux lentilles de focalisation L1 et L2 et un diaphragme de champ DC entre les lentilles. Le système afocal SAF conjugue optiquement la scène SC et le plan d'image IM sur la zone active ZA dans le spectromètre SP. Egalement le système afocal adapte le diamètre du faisceau lumineux reçu par la lentille d'entrée L1 à la taille de la face F2 du spectromètre. Le cas échéant, une lentille de champ LCH est positionnée devant le diaphragme du champ DC pour ajuster l'image de la scène sur le plan d'image IM.

Selon une deuxième configuration, le spectromètre SP reçoit le faisceau lumineux d'une scène lointaine, considérée comme une succession de portions de champ de vision linéaires PSC, à travers une lentille cylindrique LCY pour de la spectro-imagerie simultanée, comme montré à la figure 7.

L'arête A du dièdre entre les faces F1 et F2 de la lame d'interféromètre LC est positionnée sensiblement parallèle aux portions de champ de vision linéaires PSC. Une rangée formée par une ligne d'éléments photosensibles EPS parallèle à l'arête A capte une portion de champ PSC de la scène à observer dont les vues sont prises séquentiellement par balayage de la matrice d'éléments photosensibles EPS du détecteur selon une direction DD perpendiculaire à l'arête ou par défilement lors, par exemple, du déplacement d'un aéronef ayant embarqué le spectromètre SP pour visualiser une scène au sol. Une détection commandée perpendiculairement à l'arête A suivant des rangées formées par des colonnes d'éléments photosensibles EPS permet d'analyser par spectrométrie le faisceau lumineux reçu de la scène à observer.

Selon une troisième configuration montrée à la figure 8, le spectromètre SP est placé derrière un objectif de focalisation OF escamotable séquentiellement visant une scène lointaine SC afin d'assurer séquentiellement une fonction de spectrométrie et une fonction d'imagerie. Lorsque l'objectif OF est escamoté transversalement du champ devant la scène SC, le spectromètre SP est en visibilité directe avec la scène, comme à la figure 6A. Lorsque l'objectif OF est intercalé dans le champ de vision du spectromètre SP, il fonctionne en mode imagerie bidimensionnelle.

**Revendications**

1. - Spectromètre statique par transformée de Fourier comprenant des éléments photosensibles semi-conducteurs (EPS) ayant des faces actives coïncidant avec un plan d'image (IM), et un dioptre semi-réfléchissant (SM), ledit spectromètre comprenant un interféromètre essentiellement constitué par une lame, la lame (LC, LM) ayant une première face plane (F1) coïncidant avec le plan d'image (IM) sur les éléments photosensibles, et une deuxième face (F2) plane et non parallèle à la première face et supportant le dioptre semi-réfléchissant afin que l'épaisseur entre les faces de la lame, sensiblement constante en regard de chaque élément photosensible (EPS) varie régulièrement d'un élément photosensible (EPS) à un autre.

2. - Spectromètre conforme à la revendication 1, **caractérisé en ce que** la variation d'épaisseur entre les faces de la lame (LC, LM) induit une variation linéaire de différence de marche entre une valeur minimale proche de zéro et une valeur maximale avec un pas d'échantillonnage.

3. - Spectromètre conforme à la revendication 1, **caractérisé en ce que** la première face (F1) et la deuxième face (F2) de la lame (LC) forment un dièdre dont l'arête (A) est sensiblement perpendiculaire à des rangées parallèles d'éléments photosensibles (EPS).

4. - Spectromètre conforme à l'une quelconque des revendications 1 à 3, dans lequel la lame (LC, LM) est en un composé cristallin incluant un semi-conducteur.

5. - Spectromètre statique par transformée de Fourier comprenant des éléments photosensibles semi-conducteurs (EPS) ayant des faces actives coïncidant avec un plan d'image (IM), et un dioptre semi-réfléchissant (SM), ledit spectromètre comprenant un interféromètre essentiellement constitué par une lame, la lame (LC, LM) ayant une première face plane (F1) coïncidant avec le plan d'image (IM) sur les éléments photosensibles, et une deuxième face (F2) constituée de marches (MA) sensiblement aussi larges qu'au moins un élément photosensible et supportant le dioptre semi-réfléchissant afin que l'épaisseur entre les faces de la lame, sensiblement constante en regard de chaque élément photosensible (EPS) varie régulièrement d'un élément photosensible (EPS) à un autre.

6. - Spectromètre conforme à la revendication 5, **caractérisé en ce que** la deuxième face (F2) de la lame (LM) a un profil en escalier.

7. - Spectromètre conforme à la revendication 5, **caractérisé en ce que** la deuxième face (F2) de la lame (LM) a une forme pyramidale.

8. - Spectromètre conforme à l'une quelconque des revendications 5 à 7, dans lequel la lame (LC, LM) est en un composé cristallin incluant un semi-conducteur.

9. - Procédé pour fabriquer un spectromètre statique par transformée de Fourier comprenant des éléments photosensibles semi-conducteurs (EPS) ayant des faces actives coïncidant avec un plan d'image (IM), et un dioptre semi-réfléchissant (SM), ledit spectromètre comprenant un interféromètre essentiellement constitué par une lame, ledit procédé comprenant les étapes suivantes de :

- former (ET2) les éléments photosensibles (EPS) avec leurs faces actives sur une première face (F1) d'un substrat (SU) coïncidant avec le plan d'image (IM),
- amincir (ET5) le substrat (SU) en une lame (LC, LM) ayant une deuxième face (F2) plane et non parallèle à la première face (F1) afin que l'épaisseur entre les faces de la lame varie d'un élément photosensible (EPS) à l'autre, et
- déposer (ET6) une couche semi-réfléchissante formant le dioptre semi-réfléchissant sur la deuxième face.

10. - Procédé conforme à la revendication 9, comprenant une intégration (ET4) d'un circuit de lecture (CL) contre les éléments photosensibles par technique d'hybridation, après l'étape de former (ET2).

11. - Procédé conforme à la revendication 9 ou 10, comprenant un retournement (ET3) du substrat (SU) supportant les éléments photosensibles (EPS), après l'étape de former (ET2).

12. - Procédé pour fabriquer un spectromètre statique par transformée de Fourier comprenant des éléments photosensibles semi-conducteurs (EPS) ayant des faces actives coïncidant avec un plan d'image (IM), et un dioptre semi-réfléchissant (SM), ledit spectromètre comprenant un interféromètre essentiellement constitué par une lame, ledit procédé comprenant les étapes suivantes de :

- former (ET2) les éléments photosensibles (EPS) avec leurs faces actives sur une première face (F1) d'un substrat (SU) coïncidant avec le plan d'image (IM),
- amincir (ET5) le substrat (SU) en une lame (LC, LM) ayant une deuxième face (F2) constituée de marches (MA) sensiblement aussi larges qu'au moins un élément photosensible (EPS) afin que l'épaisseur entre les faces de la lame varie d'un élément photosensible (EPS) à l'autre, et
- déposer (ET6) une couche semi-réfléchissante formant le dioptre semi-réfléchissant sur la deuxième face.

13. - Procédé conforme à la revendication 12, comprenant une intégration (ET4) d'un circuit de lecture (CL) contre les éléments photosensibles par technique d'hybridation, après l'étape de former (ET2).

**14.** - Procédé conforme à la revendication 12 ou 13, comprenant un retournement (ET3) du substrat (SU) supportant les éléments photosensibles (EPS), après l'étape de former (ET2).

**Patentansprüche**

**1.** Statisches Fourier-Transformations-Spektrometer umfassend lichtempfindliche Halbleiterelemente (EPS), die aktive Flächen aufweisen, die mit einer Bildebene (IM) übereinstimmen, und einen halbreflektierenden Diopter (SM), wobei das Spektrometer ein Interferometer umfasst, das im Wesentlichen aus einer Schaufel besteht, wobei die Schaufel (LC, LM) eine erste ebene Fläche (F1) aufweist, die mit der Bildebene (IM) auf den lichtempfindlichen Elementen zusammenfällt, und eine zweite ebene Fläche (F2), die nicht parallel zur ersten Fläche verläuft und den halbreflektierenden Diopter trägt, so dass die Dicke zwischen den Flächen der Schaufel, im Wesentlichen konstant in Bezug auf jedes lichtempfindliche Element (EPS), regelmäßig von einem lichtempfindlichen Element (EPS) zu einem anderen variiert.

**2.** Spektrometer nach Anspruch 1, **dadurch gekennzeichnet, dass** die Variation der Dicke zwischen den Schaufelflächen (LC, LM) eine lineare Variation der Stufendifferenz zwischen einem Minimalwert nahe Null und einem Maximalwert mit einem Abtastschritt induziert.

**3.** Spektrometer nach Anspruch 1, **dadurch gekennzeichnet, dass** die erste Fläche (F1) und die zweite Fläche (F2) der Schaufel (LC) ein Dieder bilden, dessen Kante (A) im Wesentlichen senkrecht zu parallelen Reihen von lichtempfindlichen Elementen (EPS) verläuft.

**4.** Spektrometer nach einem der Ansprüche 1 bis 3, wobei die Schaufel (LC, LM) aus einer kristallinen Verbindung ist, die einen Halbleiter enthält.

**5.** Statisches Fourier-Transformations-Spektrometer umfassend lichtempfindliche Halbleiterelemente (EPS), die aktive Flächen aufweisen, die mit einer Bildebene (IM) übereinstimmen, und einen halbreflektierenden Diopter (SM), wobei das Spektrometer ein Interferometer umfasst, das im Wesentlichen aus einer Schaufel besteht, wobei die Schaufel (LC, LM) eine erste ebene Fläche (F1) aufweist, die mit der Bildebene (IM) auf den lichtempfindlichen Elementen zusammenfällt, und eine zweite Fläche (F2), die aus Stufen (MA) besteht, die im Wesentlichen so breit wie mindestens ein lichtempfindliches Element sind, und die den halbreflektierenden Diopter tragen, so dass die Dicke zwischen den Schaufelflächen, im Wesentlichen konstant in Bezug auf jedes lichtempfindliche Element (EPS), regelmäßig von einem lichtempfindlichen Element (EPS) zu einem anderen variiert.

**6.** Spektrometer nach Anspruch 5, **dadurch gekennzeichnet, dass** die zweite Fläche (F2) der Schaufel (LM) ein Treppenprofil aufweist.

**7.** Spektrometer nach Anspruch 5, **dadurch gekennzeichnet, dass** die zweite Fläche (F2) der Schaufel (LM) eine Pyramidenform aufweist.

**8.** Spektrometer nach einem der Ansprüche 5 bis 7, wobei die Schaufel (LC, LM) aus einer kristallinen Verbindung ist, die einen Halbleiter enthält.

**9.** Verfahren zur Herstellung eines statischen Fourier-Transformations-Spektrometers, umfassend lichtempfindliche Halbleiterelemente (EPS), die aktive Flächen aufweisen, die mit einer Bildebene (IM) zusammenfallen, und einen halbreflektierenden Diopter (SM), wobei das Spektrometer ein Interferometer umfasst, das im Wesentlichen aus einer Schaufel besteht, wobei das Verfahren die folgenden Schritte umfasst:

- Bilden (ET2) lichtempfindlicher Elemente (EPS) mit ihren aktiven Flächen auf einer ersten Fläche (F1) eines Substrats (SU), die mit der Bildebene (IM) zusammenfällt,
- Dünner machen (ET5) des Substrats (SU) in eine Schaufel (LC, LM), die eine zweite Ebene, und zur ersten Fläche (F1) nicht parallel zweite Fläche (F2) aufweist, so dass die Dicke zwischen den Schaufelflächen von einem lichtempfindlichen Element (EPS) zum anderen variiert, und
- Auflegen (ET6) einer halbreflektierenden Schicht, die auf der zweiten Fläche den halbreflektierenden Diopter bildet.

**10.** Verfahren nach Anspruch 9, umfassend das Integrieren (ET4) einer Leseschaltung (CL), das die lichtempfindlichen Elemente trägt durch Hybridisierungstechnik nach dem Schritt der Bildung (ET2).

**11.** Verfahren nach Anspruch 9 oder 10, umfassend das Umkehren (ET3) des Substrats (SU), das die lichtempfindlichen Elemente (EPS) trägt, nach dem Schritt der Bildung (ET2).

**12.** Verfahren zur Herstellung eines statischen Fourier-Transformations-Spektrometers, umfassend lichtempfindliche Halbleiterelemente (EPS), die aktive Flächen aufweisen, die mit einer Bildebene (IM) zusammenfallen, und einen halbreflektierenden Diopter (SM), wobei das Spektrometer ein Interferometer umfasst, das im Wesentlichen aus einer Schaufel besteht, wobei das Verfahren die folgenden Schritte umfasst:

- Bilden (ET2) der lichtempfindlichen Elemente (EPS) mit ihren aktiven Flächen auf einer ersten Fläche (F1) eines Substrats (SU), die mit der Bildebene (IM) zusammenfällt,
- Dünner machen (ET5) des Substrats (SU) in eine Schaufel (LC, LM), die eine zweiten Fläche (F2) aufweist, die aus Stufen (MA) besteht, die im Wesentlichen so breit wie mindestens ein lichtempfindliches Element (EPS) sind, so dass die Dicke zwischen den Schaufelflächen von einem lichtempfindlichen Element (EPS) zum anderen variiert, und
- Auflegen (ET6) einer halbreflektierenden Schicht, die auf der zweiten Fläche den halbreflektierenden Diopter bildet.

13. Verfahren nach Anspruch 12, umfassend das Integrieren (ET4) einer Leseschaltung (CL) gegen die lichtempfindlichen Elemente durch Hybridisierungstechnik nach dem Schritt der Bildung (ET2).

14. Verfahren nach Anspruch 12 oder 13, umfassend ein Umkehren (ET3) des Substrats (SU), das die lichtempfindlichen Elemente (EPS) trägt, nach dem Schritt der Bildung (ET2).

**Claims**

1. A stationary Fourier transform spectrometer comprising semiconductor photosensitive elements having active faces coinciding with an image plane, and a semi-reflecting diopter, said spectrometer comprising an interferometer essentially comprised of a plate, said plate having a first face that is plane and coincides with the image plane on said photosensitive elements, and a second face that is plane and not parallel to said first face and carries said semi-reflecting diopter in order for the thickness between said first face and second face of said plate, which is substantially constant in front of each photosensitive element, to vary regularly from one photosensitive element to another.

2. The spectrometer as claimed in claim 1, wherein the variation of said thickness between said first face and second face of said plate induces a linear variation of optical path difference between a minimum value close to zero and a maximum value with a sampling step.

3. The spectrometer as claimed in claim 1, wherein said first face and said second face of said plate form a dihedron whose edge is substantially perpendicular to parallel rows of photosensitive elements.

4. The spectrometer as claimed in any of claims 1 to 3, wherein said plate is made from a crystalline compound including a semiconductor.

5. A stationary Fourier transform spectrometer comprising semiconductor photosensitive elements having active faces coinciding with an image plane, and a semi-reflecting diopter, said spectrometer comprising an interferometer essentially comprised of a plate, said plate having a first face that coincides with the image plane on said photosensitive elements, and a second face that consists of steps substantially as wide as at least one photosensitive element and carries said semi-reflecting diopter in order for the thickness between said first face and second face of said plate, which is substantially constant in front of each photosensitive element, to vary regularly from one photosensitive element to another.

6. The spectrometer as claimed in claim 5, wherein said second face of said plate has a staircase profile.

7. The spectrometer as claimed in claim 5, wherein said second face of said plate has a pyramidal shape.

8. The spectrometer as claimed in any of claims 5 to 7, wherein said plate is made from a crystalline compound including a semiconductor.

9. A method of fabricating a stationary Fourier transform spectrometer comprising a semi-reflecting diopter and semiconductor photosensitive elements having active faces coinciding with an image plane, said spectrometer comprising an interferometer essentially comprised of a plate, which method comprises the steps of:

- forming said photosensitive elements with their active faces on a first face of a substrate coinciding with said image plane,
- thinning said substrate into a plate having a second face that is plane and not parallel to said first face in order for the thickness between the faces of said plate to vary from one photosensitive element to the other, and
- depositing on said second face a semi-reflecting layer forming said semi-reflecting diopter.

10. The method as claimed in claim 9, comprising integrating a read circuit against said photosensitive elements by means of a hybridation technique after said forming step.

**11.** The method as claimed in claims 9 or 10, comprising turning over said substrate supporting said photosensitive elements after said forming step.

**12.** A method of fabricating a stationary Fourier transform spectrometer comprising a semi-reflecting diopter and semiconductor photosensitive elements having active faces coinciding with an image plane, said spectrometer comprising an interferometer essentially comprised of a plate, which method comprises the steps of:

- forming said photosensitive elements with their active faces on a first face of a substrate coinciding with said image plane,
- thinning said substrate into a plate having a second face that consists of steps substantially as wide as at least one photosensitive element in order for the thickness between the faces of said plate to vary from one photosensitive element to the other, and
- depositing on said second face a semi-reflecting layer forming said semi-reflecting diopter.

**13.** The method as claimed in claim 9, comprising integrating a read circuit against said photosensitive elements by means of a hybridation technique after said forming step.

**14.** The method as claimed in claims 13 or 14, comprising turning over said substrate supporting said photosensitive elements after said forming step.

**Fig. 1**

**Fig. 2**

**Fig. 4**

**Fig. 5**

**Fig. 3**

**Fig. 6A**

SC

SP

LC — ZA,CL

**Fig. 6B**

L1   LCH   DC

SC

SAF

L2

SP

F2 — ZA,CL

IM

**Fig. 7**

DD

colonne
spectrométrie

ZA,CL

F1

SP

LC

F2

ligne
imagerie

A

LCY

PSC

**Fig. 8**

OF

SC

ZA,CL

LC — SP

## RÉFÉRENCES CITÉES DANS LA DESCRIPTION

**Documents brevets cités dans la description**

- US 6016199 A
- US 4822998 A
- CA 4820998

**Littérature non-brevet citée dans la description**

- **M.-L. JUNTTILA et al.** Performance limits of stationary Fourier spectrometers. *Journal of Optical Society of America,* Septembre 1991, vol. 8 (9), 1457-1462
- **OMAR MANZARDO et al.** Miniaturized time-scanning Fourier transform spectrometer based on silicon technology. *Optics Letters,* Décembre 1999, vol. 24 (23), 1705-1707
- **H.E. SNELL et al.** Fourier Transform Fabry-Pérot Interferometer. *SPIE-International Society for Optical Engineering,* 29 Juin 1992, vol. 1745, 158-163
- **PHILIPPE VOGE ; JÉRÔME PRIMOT.** Simple infrared Fourier transform spectrometer adapted to low light level and high-speed. *Optical Engineering,* Septembre 1998, vol. 37 (9), 2459-2466